# EUROPEAN PATENT APPLICATION

(11) **EP 4 730 454 A1**
(43) Date of publication of application: **22.04.2026**
(21) Application number: 24889215.0
(22) Date of filing: 11.11.2024
(51) Int. Cl.: H01M 10/04, H01M 10/44, H01M 10/42, H01M 10/052, G01R 1/04, G01R 31/385

(54) **PRESSING STRUCTURE FOR LITHIUM SULFUR BATTERY, AND BATTERY MODULE AND BATTERY PACK INCLUDING SAME**

(30) Priority: 09.11.2023 KR 20230154878
(71) Applicant: LG Energy Solution, Ltd., Seoul 07335 (KR)
(72) Inventor: HONG, Kyung-Sik, Daejeon 34122 (KR)
(74) Representative: Goddar, Heinz J.
(86) International application number: PCT/KR2024/017771
(87) International publication number: WO 2025/101029

(57) **Abstract**

A pressing structure according to an aspect of the present disclosure includes a first plate on which at least one lithium-sulfur battery is mounted; a second plate spaced a predetermined distance apart from an upper surface of the first plate; and a first buffer member connecting the first plate to the second plate, wherein the first buffer member changes in length in response to the distance between the first plate and the second plate.

The pressing structure may suppress porosification in a negative electrode and dendrite formation on the negative electrode surface during charging and discharging of the lithium-sulfur battery. Additionally, the pressing structure for charge and discharge of the lithium-sulfur battery may maintain the structure of a positive electrode during discharging of the lithium-sulfur battery.

## Description

### TECHNICAL FIELD

The present disclosure relates to a pressing structure for a lithium-sulfur battery, and a battery module and a battery pack including the same.

This application is based on and claims priority from Korean Patent Application No. 10-2023-0154878 filed on November 9, 2023, with the Korean Intellectual Property Office, the disclosure of which is incorporated herein in its entirety by reference.

### BACKGROUND

As the range of applications of lithium secondary batteries is extended to portable electronic devices as well as electric vehicles (EV) and electric storage systems (ESS), there is a growing demand for lithium secondary batteries with high capacity, high energy density, and long life.

Lithium metal batteries were first commercialized in the industry of lithium secondary batteries, and include lithium metal for a negative electrode, and lithium is very light and has the possibility of achieving high energy density due to its theoretical capacity of more than 3800 mAh/g. However, as opposed to graphite-based negative electrode materials, the lithium metal negative electrode has problems with porosification in the negative electrode by repeated lithium intercalation and deintercalation during charging and discharging, and dendrite formation on the negative electrode surface due to uneven lithium intercalation. Accordingly, to suppress the porosification in the negative electrode and the dendrite formation on the negative electrode surface, batteries generally work at high pressure.

Meanwhile, in lithium-sulfur batteries including sulfur-based materials as positive electrode active materials, sulfur, the main material of the positive electrode active material, has low atomic weight, is abundant and readily available, and has low cost, low toxicity and eco-friendliness advantages. In lithium-sulfur batteries, during discharging, when sulfur accepts electrons, reduction reaction occurs at the positive electrode to produce lithium polysulfides (Li₂Sₓ, x = 2 to 8) at the positive electrode, and some of them easily dissolve in an electrolyte solution. Accordingly, the structure of the positive electrode of the lithium-sulfur battery is weakened during discharging.

When pressure is applied to the lithium-sulfur battery including lithium in the negative electrode and the sulfur-based material in the positive electrode to suppress the porosification in the negative electrode and dendrite formation on the negative electrode surface, the positive electrode having the weakened structure during discharging does not maintain the structure.

### DISCLOSURE

### Technical Problem

The present disclosure is designed to solve the above-described problems, and therefore the present disclosure is directed to providing a pressing structure of a lithium-sulfur battery for suppressing porosification in a negative electrode and preventing dendrite formation on the negative electrode surface during charging and discharging of the lithium-sulfur battery.

The present disclosure is further directed to providing a pressing structure for a lithium-sulfur battery for maintaining the structure of a positive electrode by limiting the load applied to the positive electrode to suppress the weakening of the structure of the positive electrode due to the elution of lithium polysulfide during discharging.

The present disclosure is further directed to providing a battery module including the pressing structure and a battery pack including the pressing structure.

The present disclosure is further directed to providing a device including the battery pack.

### Technical Solution

To achieve the above-described objective,
according to an aspect of the present disclosure, there are provided a pressing structure, a battery module and a battery pack of the following embodiments.

The pressing structure according to a first embodiment includes:
a first plate on which at least one lithium-sulfur battery is mounted;
a second plate spaced a predetermined distance apart from an upper surface of the first plate; and
a first buffer member connecting the first plate to the second plate,
wherein the first buffer member changes in length in response to the distance between the first plate and the second plate.

According to a second embodiment, in the first embodiment,
the pressing structure further includes: a third plate spaced a predetermined distance apart from an upper surface of the second plate; and
a second buffer member connecting the second plate to the third plate,
wherein the second buffer member changes in length in response to the distance between the second plate and the third plate.

According to a third embodiment, in the first or second embodiment,
the pressing structure further includes a first stopper located on the upper surface of the first plate and protruded toward a lower surface of the second plate,
wherein the first stopper stops the distance between the first plate and the second plate from decreasing below a predetermined distance.

According to a fourth embodiment, in any one of the first to third embodiments,
the pressing structure further includes a first stopper located on a lower surface of the second plate and protruded toward the upper surface of the first plate,
wherein the first stopper stops the distance between the first plate and the second plate from decreasing below a predetermined distance.

According to a fifth embodiment, in the second embodiment,
the pressing structure further includes a second stopper located on the upper surface of the second plate and protruded toward a lower surface of the third plate,
wherein the second stopper stops the distance between the second plate and the third plate from decreasing below a predetermined distance.

According to a sixth embodiment, in the second or fifth embodiment,
the pressing structure further includes a second stopper located on a lower surface of the third plate and protruded toward the upper surface of the second plate,
wherein the second stopper stops the distance between the second plate and the third plate from decreasing below a predetermined distance.

According to a seventh embodiment, in the second, fifth or sixth embodiment,
an elastic modulus of the first buffer member is greater than an elastic modulus of the second buffer member.

In an eighth embodiment, in any one of the second and fifth to seventh embodiments,
each of the first buffer member and the second buffer member includes independently a spring or a rubber.

The battery module according to a ninth embodiment includes:
a module case including a lower module case and an upper module case defining an internal space;
a pressing structure which is housed in the internal space and in which at least one lithium-sulfur battery cell is inserted; and
a frame to which the pressing structure is connected,
wherein the pressing structure is the pressing structure according to any one of the first to eighth embodiments.

According to a tenth embodiment, in the ninth embodiment,
the frame has a bar or plate shape of a parallel structure.

According to an eleventh embodiment, in the ninth or tenth embodiment,
the frame includes an actuator,
the actuator is connected to the first plate and the second plate,
the first plate and the second plate are moved in a vertical direction by the actuator, and
the pressing structure presses the lithium-sulfur battery by the movement of the first plate and the second plate.

The battery pack according to a twelfth embodiment includes:
a battery pack case including a lower battery pack case and an upper battery pack case defining an internal space;
a cross beam to divide the internal space into a plurality of accommodation rooms; and
a battery module which is housed in the accommodation room,
wherein the battery module is the battery module according to any one of the ninth to eleventh embodiments.

The battery pack according to a thirteenth embodiment includes:
a battery pack case including a lower battery pack case and an upper battery pack case defining an internal space;
a cross beam to divide the internal space into a plurality of accommodation rooms;
a pressing structure which is housed in the accommodation room, and in which at least one lithium-sulfur battery cell is inserted; and
a frame to which the pressing structure is connected,
wherein the pressing structure is the pressing structure according to any one of the first to ninth embodiments.

A device according to a fourteenth embodiment includes the battery pack according to the twelfth embodiment.

A device according to a fifteenth embodiment includes the battery pack according to the thirteenth embodiment.

### Advantageous Effects

The pressing structure according to an embodiment of the present disclosure includes the first buffer member connecting the first plate on which the lithium-sulfur battery is mounted to the second plate spaced the predetermined distance apart from the upper surface of the first plate, the first buffer member changing in length in response to the distance between the first plate and the second plate, in order to apply the predetermined pressure to the negative electrode during charging and discharging, thereby suppressing porosification in the negative electrode (especially porosification of lithium) and dendrite formation on the negative electrode surface during charging and discharging.

The pressing structure according to an embodiment of the present disclosure may further include the third plate spaced the predetermined distance apart from the upper surface of the second plate, and the second buffer member connecting the second plate to the third plate, the second buffer member changing in length in response to the distance between the second plate and the third plate, or the stopper to stop the distance between at least one of the first plate to the third plate and its facing plate from decreasing below the predetermined distance, or may adjust the elastic modulus of the first and second buffer members, in order to limit the pressure applied to the positive electrode, thereby maintaining the structure of the positive electrode during discharging of the lithium-sulfur battery.

### BRIEF DESCRIPTION OF THE DRAWINGS

The accompanying drawings illustrate the exemplary embodiments of the present disclosure and together with the foregoing disclosure, serve to provide a better understanding of the technical aspect of the present disclosure, and thus the present disclosure is not construed as being limited to the drawings. In the drawings, for clarity of description, the shape, size, scale or proportion of the elements may be exaggerated for emphasis.
FIG. 1 is a diagram showing a conventional pressing structure.
FIG. 2 is a diagram showing the operation of a conventional pressing structure.
FIG. 3 is a diagram showing a conventional pressing structure.
FIG. 4 is a diagram showing the operation of a conventional pressing structure.
FIG. 5 is a diagram showing a pressing structure according to an embodiment of the present disclosure.
FIG. 6 is a diagram showing the operation of a pressing structure according to an embodiment of the present disclosure.
FIG. 7 is a diagram showing a pressing structure according to an embodiment of the present disclosure.
FIG. 8 is a diagram showing the operation of a pressing structure according to an embodiment of the present disclosure.
FIG. 9 shows pressure changes during charging and discharging of a lithium-sulfur battery by the operation of a pressing structure according to an embodiment of the present disclosure.
FIG. 10 is a diagram showing the comparison of discharge capacity vs cycle in a lithium-sulfur battery applied to a pressing structure according to Example 1 of the present disclosure and a lithium-sulfur battery applied to a conventional pressing structure according to Comparative Example 1.
FIG. 11 is a diagram showing a pressing structure according to an embodiment of the present disclosure.
FIG. 12 is a diagram showing the operation of a pressing structure according to an embodiment of the present disclosure.
FIG. 13 shows the applied pressure vs State Of Charge (SOC) in a lithium-sulfur battery by the operation of a pressing structure according to an embodiment of the present disclosure.
FIG. 14 is a diagram showing a pressing structure according to an embodiment of the present disclosure.
FIG. 15 is a diagram showing the operation of a pressing structure according to an embodiment of the present disclosure.
FIG. 16 shows the pressure at SOC 100 vs cycle in a lithium-sulfur battery applied to a pressing structure according to an embodiment of the present disclosure.
FIG. 17 is a diagram showing a plurality of lithium-sulfur batteries applied horizontally to a pressing structure according to an embodiment of the present disclosure.
FIG. 18 is a diagram showing lithium sulfur batteries applied vertically to a pressing structure according to an embodiment of the present disclosure.
FIG. 19 is a cross-sectional view of a battery module according to an embodiment of the present disclosure.
FIG. 20 is a schematic perspective view of a battery pack according to an embodiment of the present disclosure.
FIG. 21 is a schematic perspective view of a battery pack according to an embodiment of the present disclosure.

### BEST MODE

Hereinafter, the present disclosure will be described in detail with reference to the accompanying drawings. It should be understood that the terms used in the specification and the appended claims should not be construed as limited to general and dictionary meanings, and rather, should be interpreted based on the meanings and concepts corresponding to technical aspects of the present disclosure on the basis of the principle that the inventor is allowed to define the terms appropriately for the best explanation.

Accordingly, the embodiments described herein and the illustrations in the drawings are provided to describe the present disclosure by way of example but not intended to be limiting, so it should be understood that a variety of other equivalents and modifications could have been made thereto at the time the application was filed.

It should be further understood that "include", "comprise" or "have" when used in this specification, specifies the presence of stated elements and does not preclude the presence or addition of one or more other elements unless expressly stated otherwise.

In this specification, 'A and/or B' as used herein refers to either A or B or both.

Throughout this specification, BOL stands for Beginning Of Life, and may refer to the initial state of a battery, and a state in which 100% of the battery capacity remains. The 100% remaining battery capacity may represent that the initial battery capacity is maintained irrespective of charge/discharge. That is, it may refer to 100% capacity retention.

Throughout this specification, EOL stands for End Of Life, and may refer to a state of a degraded battery, and a state in which 60% of the battery capacity remains. The 60% remaining battery capacity may represent that 60% of the initial battery capacity remains irrespective of charge/discharge. That is, it may refer to 60% capacity retention.

The first aspect of the present disclosure relates to a pressing structure for charge and discharge of a lithium-sulfur battery. Hereinafter, conventional pressing structures and various types of pressing structures for lithium-sulfur batteries according to the present disclosure will be specifically described with reference to the drawings.

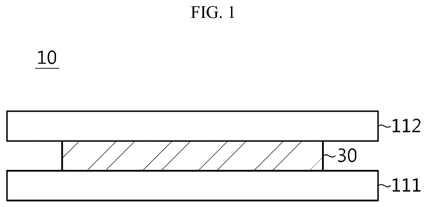

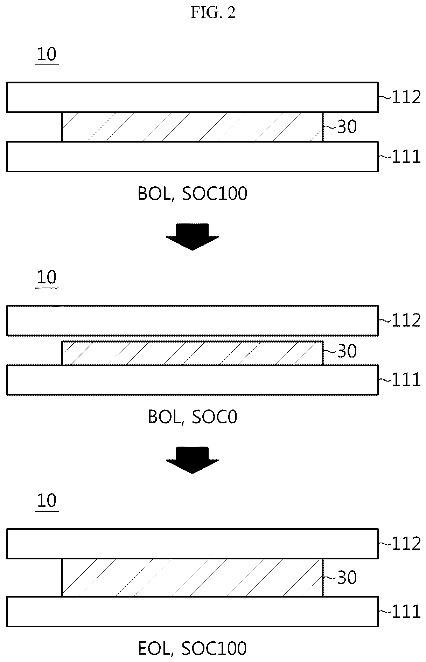

FIG. 1 is a diagram showing a conventional pressing structure 10 for charge and discharge for pressing a lithium-sulfur battery 30. FIG. 2 is a diagram showing the operation of the pressing structure 10 according to FIG. 1.

Referring to FIG. 1, the conventional pressing structure 10 includes a first plate 111 and a second plate 112, and the lithium-sulfur battery 30 may be inserted in between the first plate 111 and the second plate 112.

The operation of the conventional pressing structure 10 will be described with reference to FIG. 2.

The charged lithium-sulfur battery 30 at BOL may be inserted in between the first plate 111 and the second plate 112 of the pressing structure 10, and the first plate 111 and the second plate 112 may press the lithium-sulfur battery 30 from two sides to apply pressure to the lithium-sulfur battery 30 in order to suppress porosification in the negative electrode during discharging.

Subsequently, the lithium-sulfur battery 30 is discharged, and the structure of the positive electrode is weakened, and by the discharge, the thickness of the lithium-sulfur battery 30 is reduced, so the load applied to the lithium-sulfur battery 30 may be removed and the structure of the positive electrode may be maintained.

However, when the volume expands as the lithium-sulfur battery 30 degrades (EOL), the distance between the first plate 111 and the second plate 112 cannot increase, so overpressure is applied to the lithium-sulfur battery 30. The positive electrode of the lithium-sulfur battery 30 has high porosity, and the structure of parts of the positive electrode is weakened during discharging due to lithium sulfide elution during discharging. When overpressure is applied to the degraded lithium-sulfur battery 30 (BOL), the structure of the positive electrode cannot be maintained.

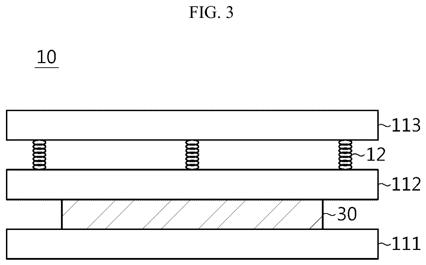

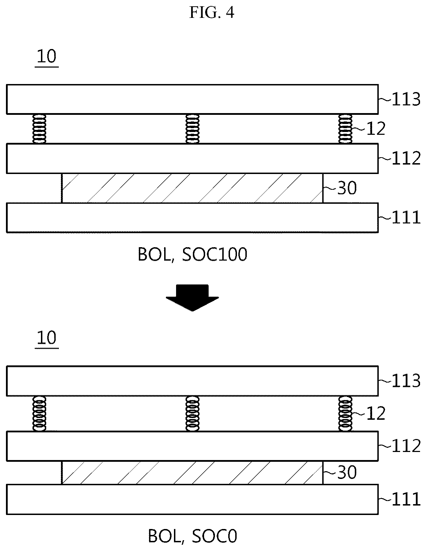

FIG. 3 is a diagram showing the conventional pressing structure 10 for charge and discharge used in the lithium-sulfur battery 30. FIG. 4 is a diagram showing the operation of the pressing structure 10 according to FIG. 3.

Referring to FIG. 3, another conventional pressing structure 10 for charge and discharge for pressing the lithium-sulfur battery 30 includes the first plate 111, the second plate 112 and a third plate 113, and the lithium-sulfur battery 30 is inserted in between the first plate 111 and the second plate 112, and a buffer member 12 is included between the second plate 112 and the third plate 113.

The operation of the conventional pressing structure 10 will be described with reference to FIG. 4.

The charged lithium-sulfur battery 30 at BOL may be inserted in between the first plate 111 and the second plate 112 of the pressing structure 10, and the first plate 111 and the third plate 113 may press the lithium-sulfur battery 30 from two sides to apply pressure to the lithium-sulfur battery 30. In this instance, as the length of the buffer member 12 is reduced, the force may accumulate.

Subsequently, the lithium-sulfur battery 30 is discharged and the structure of the positive electrode is weakened, and by the discharge, the thickness of the lithium-sulfur battery 30 is reduced. Additionally, the second plate 112 applies pressure to the lithium-sulfur battery 30 having the reduced thickness by the accumulated force in the buffer member 12. As described above, because the structure of the positive electrode is weakened during discharging of the lithium-sulfur battery 30, the structure of the positive electrode may not be maintained by the pressure applied from the second plate 112 and eventually collapse.

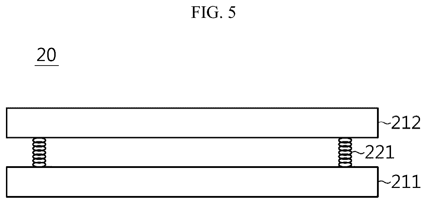

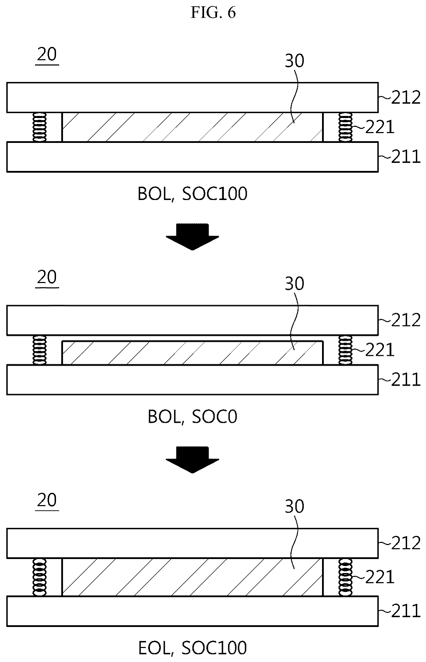

FIG. 5 is a diagram showing a pressing structure 20 for charge and discharge of a lithium-sulfur battery according to an embodiment of the present disclosure, and FIG. 6 is a diagram showing the operation of the pressing structure 20 according to FIG. 5.

Referring to FIG. 5, the pressing structure 20 for charge and discharge of the lithium-sulfur battery according to an aspect of the present disclosure includes a first plate 211, a second plate 212 and a first buffer member 221.

The first plate 211 and the second plate 212 face each other and are spaced a predetermined distance apart from each other. The first plate 211 and the second plate 212 may be configured to press one or more lithium-sulfur batteries or lithium-sulfur cells inserted in the space between them from two sides. The distance between the first plate 211 and the second plate 212 may be adjusted according to the size of the lithium-sulfur battery to be inserted, for example, thickness. To this end, the first plate 211 and/or the second plate 212 may be configured to move in a direction closer to or farther away from each other. That is, the distance between the first plate 211 and the second plate 212 may be appropriately adjusted, taking into account the thickness of the lithium-sulfur battery to be inserted.

The first plate 211 and the second plate 212 may be made of a rigid material, for example, a metal material and/or an insulating material (for example, glass or reinforced plastic), and the first plate 211 and the second plate 212 made of the exemplary material may provide strong support when pressing the lithium-sulfur battery. In addition, the first plate 211 and the second plate 212 may be made of a silicone elastomer. When the insulating material is glass, it may be possible to prevent a flow of charge/discharge current, thereby ensuring safety and accuracy in the battery test process.

The first plate 211 and/or the second plate 212 may have a charge/discharge path connecting an external charger/discharger to the lithium-sulfur battery. For example, the first plate 211 may include a charge/discharge circuit, and the lithium-sulfur battery may be charged when it is connected to the charge/discharge circuit of the first plate 211.

The first plate 211 and/or the second plate 212 may have a fixing device on which the lithium-sulfur battery may be mounted. For example, the first plate 211 may include a fixing band, and the lithium-sulfur battery may be mounted on the fixing band.

The first buffer member 221 may connect the first plate 211 to the second plate 212. The first buffer member 221 may be connected to the first plate 211 and the second plate 212 at any location where there is no interference with the lithium-sulfur battery to be mounted and a terminal connected to the lithium-sulfur battery. For example, when the first plate 211 and the second plate 212 have a rectangular shape and are vertically stacked, the first buffer member 221 may connect two end portions of the first plate 211 to two end portions of the second plate 212 corresponding to them. In addition, the first buffer member 221 may be connected to the proximity of each corner of the first plate 211 and the second plate 212.

Additionally, during operation of the pressing structure 20, the length of the first buffer member 221 may change in response to the distance between the first plate 211 and the second plate 212. For example, when the distance between the first plate 211 and the second plate 212 increases, the first buffer member 221 may stretch, and when the distance between the first plate 211 and the second plate 212 decreases, the first buffer member 221 may shrink.

To this end, the first buffer member 221 may include a material having elasticity. For example, the first buffer member 221 may include a porous silicone elastomer, a spring or a rubber-based material. The properties of the first buffer member 221 such as elastic modulus or length may be differently applied depending on the distance between the first plate 211 and the second plate 212, the type of the lithium-sulfur battery applied or the charge/discharge condition.

Through this configuration, the lithium-sulfur battery may be inserted into the space between the first plate 211 and the second plate 212, the first plate 211 and the second plate 212 may change in location in response to a change in the volume of the inserted lithium-sulfur battery, and in response to the change, the first buffer member 221 may stretch or shrink.

The operation of the pressing structure 20 will be described with reference to FIG. 6.

The lithium-sulfur battery 30 charged to State Of Charge (SOC) 100 (BOL) is inserted in between the first plate 211 and the second plate 212 of the pressing structure 20. To suppress porosification of the negative electrode, the first plate 211 and the second plate 212 may press the lithium-sulfur battery 30 from two sides to apply pressure to the lithium-sulfur battery 30. Subsequently, the lithium-sulfur battery 30 discharged from BOL to SOC 0 may be reduced in thickness, so the load applied to the lithium-sulfur battery 30 may be reduced and the structure of the positive electrode may be maintained. In this instance, the first buffer member 221 may shrink to a smaller extent than the extent to which the lithium-sulfur battery 30 is reduced in thickness. That is, the length of the first buffer member 221 may be reduced to some extent and the first plate 211 and the second plate 212 may get closer to each other, but the force accumulated in the first buffer member 221 may regulate the extent to which the first plate 211 and the second plate get closer to each other.

When the volume expands as the lithium-sulfur battery 30 degrades (EOL), the first buffer member 221 increases in length and accommodates the expanded volume of the lithium-sulfur battery 30, so the lithium-sulfur battery 30 may avoid overpressure, thereby suppressing the weakening of the structure of the positive electrode, and maintaining the positive electrode structure without collapse.

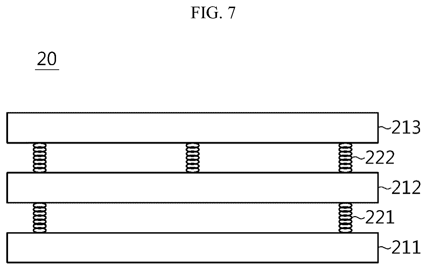

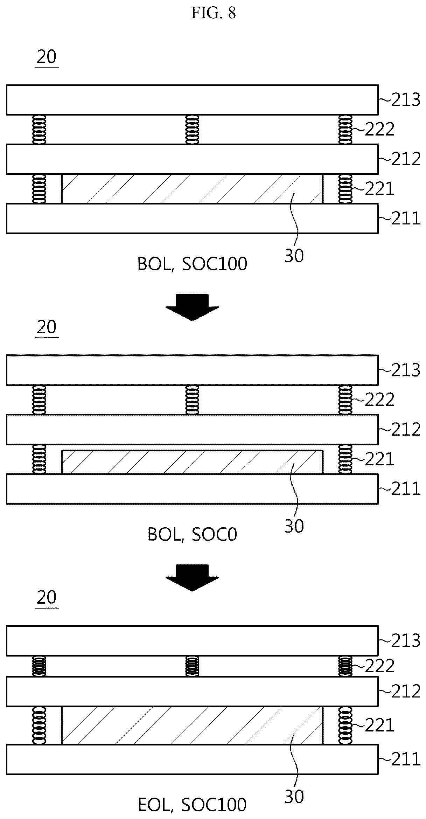

FIG. 7 is a diagram showing the pressing structure 20 for charge and discharge of the lithium-sulfur battery according to an aspect of the present disclosure, and FIG. 8 is a diagram showing the operation of the pressing structure 20 according to FIG. 7.

Referring to FIG. 7, the pressing structure 20 for charge and discharge of the lithium-sulfur battery according to an aspect of the present disclosure includes the first plate 211, the second plate 212, a third plate 213, the first buffer member 221 and a second buffer member 222. That is, in addition to the pressing structure for charge and discharge shown in FIG. 5, the pressing structure 20 for charge and discharge shown in FIG. 7 further includes the third plate 213 and the second buffer member 222.

The first plate 211, the second plate 212 and the third plate 213 may be made of a rigid material, for example, a metal material and/or an insulating material (for example, glass or reinforced plastic), and the first plate 211, the second plate 212 and the third plate 213 made of the exemplary material may provide strong support when pressing the lithium-sulfur battery. In addition, the first plate 211, the second plate 212 and the third plate 213 may be made of a silicone elastomer. When the insulating material is glass, it may be possible to prevent a flow of charge/discharge current, thereby ensuring safety and accuracy in the battery test process. To this end, the second buffer member 222 may include a material having elasticity. For example, the second buffer member 222 may include a porous silicone elastomer, a spring or a rubber-based material. The properties of the second buffer member 222 such as elastic modulus or length may be applied differently depending on the distance between the first plate 211 and the second plate 212, the type of the lithium-sulfur battery applied or the charge/discharge condition.

The second plate 212 and the third plate 213 face each other and are spaced a predetermined distance apart from each other. In addition, the second plate 212 and the third plate 213 may be connected by the second buffer member 222.

The second buffer member 222 may be connected to the second plate 212 and the third plate 213 at any location. For example, when the second plate 212 and the third plate 213 have a rectangular shape and are stacked in the vertical direction, the second buffer member 222 may be located at the opposite two end portions and the central portion of the second plate 212 and the third plate 213.

The second buffer member 222 may change in length in response to the distance between the second plate 212 and the third plate 213. For example, when the distance between the second plate 212 and the third plate 213 increases, the second buffer member may stretch, and when the distance between the second plate 212 and the third plate 213 decreases, the second buffer member 222 may shrink.

The elastic modulus of the first buffer member 221 may be greater than the elastic modulus of the second buffer member 222. When the elastic modulus of the first buffer member 221 is greater than the elastic modulus of the second buffer member 222, it may be possible to prevent the application of overpressure to the lithium-sulfur battery inserted into the pressing structure, and suppress porosification in the negative electrode and lithium dendrite formation.

The operation of the pressing structure will be described with reference to FIG. 8.

The lithium-sulfur battery 30 charged to SOC 100 (BOL) may be inserted in between the first plate 211 and the second plate 212 of the pressing structure 20, and the first plate 211 and the third plate 213 may press the lithium-sulfur battery 30 from two sides to apply pressure to the lithium-sulfur battery 30. In this instance, as the length of the second buffer member 222 is reduced, the second buffer member 222 may store the force.

Subsequently, the lithium-sulfur battery 30 discharged from BOL to SOC 0 reduces in thickness, and the compressed second buffer member 222 subjected to the pressure stretches and applies pressure to the second plate 212 toward the lithium-sulfur battery 30. However, because the elastic modulus of the first buffer member 221 is greater than the elastic modulus of the second buffer member 222, the first buffer member 221 applies higher pressure to the second plate 212 in the opposite direction to the lithium-sulfur battery 30. Accordingly, overpressure is not transmitted to the lithium-sulfur battery 30, thereby suppressing the weakening of the structure of the positive electrode, and maintaining the structure of the positive electrode without collapse.

When the volume expands as the lithium-sulfur battery 30 degrades (EOL), the first buffer member increases in length and accommodates the expanded volume of the lithium-sulfur battery 30, so the lithium-sulfur battery 30 may avoid overpressure, thereby suppressing the weakening of the structure of the positive electrode, and maintaining the structure of the positive electrode without collapse.

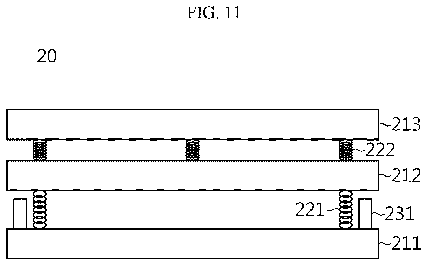

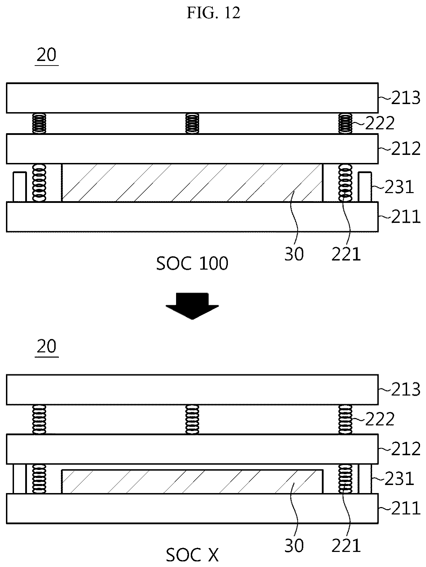

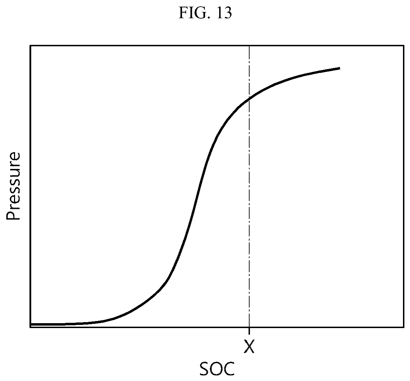

FIG. 11 is a diagram showing the pressing structure 20 for charge and discharge of the lithium-sulfur battery according to an aspect of the present disclosure, and FIG. 12 is a diagram showing the operation of the pressing structure 20 according to FIG. 11. In addition, FIG. 13 shows the applied pressure vs SOC (State Of Charge) in the lithium-sulfur battery during the operation of the pressing structure according to FIG. 12.

Referring to FIG. 11, the pressing structure 20 for charge and discharge of the lithium-sulfur battery according to an aspect of the present disclosure includes the first plate 211, the second plate 212, the third plate 213, the first buffer member 221, the second buffer member 222 and a first stopper 231. That is, in addition to the pressing structure 20 for charge and discharge shown in FIG. 7, the pressing structure 20 for charge and discharge shown in FIG. 11 further includes the first stopper 231.

The first stopper 231 may be located on the upper surface of the first plate 211 and protruded toward the lower surface of the second plate 212. In addition, the first stopper 231 may stop the distance between the first plate 211 and the second plate 212 from decreasing below a predetermined distance. For example, when the distance between the first plate 211 and the second plate 212 becomes narrow, then the distance between the first plate 211 and the second plate 212 is equal to the height of the first stopper 231, the first stopper 231 stops the first plate 211 and the second plate 212 from getting closer any longer.

To this end, the first stopper 231 may be made of a rigid material, for example, a metal material or an insulating material such as glass or reinforced plastic, and the first stopper 231 made of the exemplary material may provide strong support.

The operation of the pressing structure will be described with reference to FIG. 12.

The lithium-sulfur battery 30 charged to SOC 100 (BOL) may be inserted in between the first plate 211 and the second plate 212 of the pressing structure, and the first plate 211 and the third plate 213 may press the lithium-sulfur battery 30 from two sides to apply pressure to the lithium-sulfur battery 30. Subsequently, the lithium-sulfur battery 30 is discharged (SOC X, 0<X<100) and reduced in thickness. In this instance, when the second buffer member 222 presses down the second plate 212, then the first plate 211 and the second plate 212 get closer to each other, the first stopper 231 stops the distance between the first plate 211 and the second plate 212 from decreasing below the predetermined distance. Accordingly, it may be possible to prevent the application of pressure to the discharged lithium-sulfur battery 30, thereby suppressing the weakening of the structure of the positive electrode during discharging, and maintaining the structure of the positive electrode without collapse.

Referring to FIG. 13, when the charged lithium-sulfur battery 30 of FIG. 12 is discharged and the SOC is reduced to a random value X (0<X<100), the volume of the lithium-sulfur battery 30 may decrease and the pressure applied to the lithium-sulfur battery 30 may drop. In particular, the pressure applied to the lithium-sulfur battery 30 may sharply drop as soon as the first stopper 231 stops the distance between the first plate 211 and the second plate 212 from decreasing.

In an embodiment of the present disclosure, the first stopper may be located on the upper surface of the first plate and protruded toward the lower surface of the second plate as described above. Alternatively, the first stopper may be located on the lower surface of the second plate and protruded toward the upper surface of the first plate. In either case, the first stopper may stop the distance between the first plate and the second plate from decreasing below the predetermined distance.

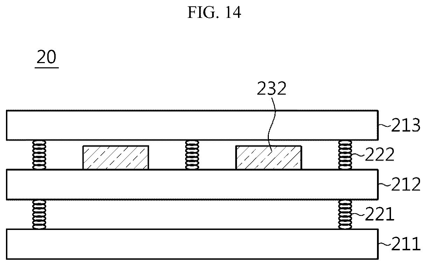

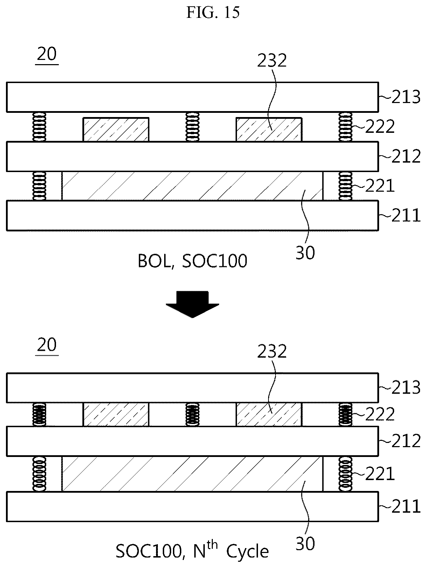

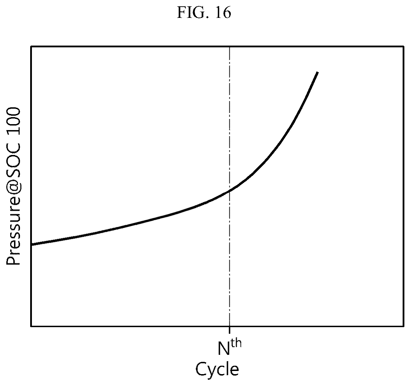

FIG. 14 is a diagram showing the pressing structure 20 for charge and discharge of the lithium-sulfur battery according to an embodiment of the present disclosure, and FIG. 15 is a diagram showing the operation of the pressing structure 20 according to FIG. 14. In addition, FIG. 16 shows the pressure at SOC 100 vs cycle during charging and discharging of the lithium-sulfur battery applied to the pressing structure according to FIG. 15.

Referring to FIG. 14, the pressing structure 20 for charge and discharge of the lithium-sulfur battery according to an aspect of the present disclosure includes the first plate 211, the second plate 212, the third plate 213, the first buffer member 221, the second buffer member 222 and a second stopper 232. That is, in addition to the pressing structure 20 for charge and discharge shown in FIG. 7, the pressing structure 20 for charge and discharge shown in FIG. 14 further includes the second stopper 232.

The second stopper 232 may be located on the upper surface of the second plate 212 and protruded toward the lower surface of the third plate 213. In addition, the second stopper 232 may stop the distance between the second plate 212 and the third plate 213 from decreasing below a predetermined distance. For example, when the distance between the second plate 212 and the third plate 213 becomes narrow, then the distance between the second plate 212 and the third plate 213 is equal to the height of the second stopper 232, the second stopper 232 stops the second plate 212 and the third plate 213 from getting closer any longer.

To this end, the second stopper 232 may be made of a rigid material, for example, a metal material or an insulating material such as glass or reinforced plastic, and the second stopper 232 made of the exemplary material may provide strong support.

Referring to FIG. 15, the lithium-sulfur battery 30 charged to SOC 100 (BOL) may be inserted in between the first plate 211 and the second plate 212 of the pressing structure 20, and the first plate 211 and the third plate 213 may press the lithium-sulfur battery 30 from two sides to apply pressure to the lithium-sulfur battery 30. Subsequently, the degraded (EOL) lithium-sulfur battery 30 may expand and increase in volume, then the distance between the first plate 211 and the second plate 212 may increase. In this instance, when the distance between the first plate 211 and the second plate 212 is overly large, the lithium-sulfur battery 30 may not be pressed, thereby failing to suppress porosification in the negative electrode. However, the pressing structure 20 according to an aspect of the present disclosure includes the second stopper 232 to stop the distance between the second plate 212 and the third plate 213 from decreasing below the predetermined distance. Accordingly, it may be possible to prevent the first plate 211 and the second plate 212 from being too far apart from each other. Accordingly, it may be possible to apply proper pressure to the lithium-sulfur battery 30, thereby suppressing porosification in the negative electrode.

Referring to FIG. 16, when the lithium-sulfur battery is applied to the pressing structure according to FIG. 15 and charging and discharging is performed, as charge/discharge cycles increase, the pressure increases in the N-th charge/discharge cycle (N is a natural number). When the negative electrode expands as it degrades, the second plate rises but cannot rise any further due to the second stopper, and the pressure of the expanding negative electrode increases. Accordingly, it may be possible to apply proper pressure to the negative electrode, thereby suppressing porosification in the negative electrode.

In an embodiment of the present disclosure, the second stopper may be located on the upper surface of the second plate and protruded toward the lower surface of the third plate as described above. Alternatively, the second stopper may be located on the lower surface of the third plate and protruded toward the upper surface of the second plate. In either case, the second stopper may stop the distance between the second plate and the third plate from decreasing below the predetermined distance.

In an embodiment of the present disclosure, the pressing structure may include all the first plate, the second plate, the third plate, the first buffer member, the second buffer member, the first stopper and the second stopper.

In an embodiment of the present disclosure, the pressing structure may mount at least one lithium-sulfur battery cell of the lithium-sulfur battery.

In an embodiment of the present disclosure, the pressing structure may press one or more lithium-sulfur batteries at the same time. Specifically, the pressing structure may press the plurality of lithium-sulfur batteries arranged horizontally side by side, and may press the plurality of lithium sulfur batteries stacked vertically.

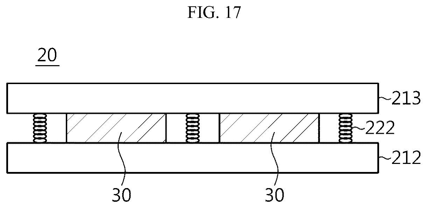

FIG. 17 shows that the pressing structure 20 according to an aspect of the present disclosure presses the lithium-sulfur batteries 30 arranged horizontally. Referring to FIG. 17, the lithium-sulfur batteries 30 may be mounted on the first plate 211 side by side and located between the first plate 211 and the second plate 212. The lithium-sulfur batteries 30 may be electrically connected to each other, and the buffer member 221 may be disposed at a located where there is no interference with the lithium-sulfur batteries 30.

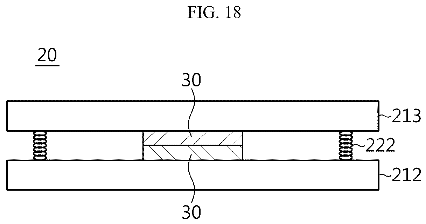

FIG. 18 shows that the pressing structure 20 according to an aspect of the present disclosure presses the lithium-sulfur batteries 30 arranged vertically. Referring to FIG. 18, the lithium-sulfur batteries 30 stacked may be mounted on the first plate 211 and located between the first plate 211 and the second plate 212. The lithium-sulfur batteries 30 may be electrically connected to each other.

A second aspect of the present disclosure relates to a battery module including the pressing structure.

The battery module according to an aspect of the present disclosure includes:
a module case including a lower module case and an upper module case defining an internal space;
a pressing structure which is housed in the internal space and into which at least one lithium-sulfur battery cell is inserted; and
a frame to which the pressing structure is connected,
wherein the pressing structure is the pressing structure according to an aspect of the present disclosure.

In an embodiment of the present disclosure, the lower module case may have a shape of a box having an open top. In addition, the upper module case may be mechanically coupled to the lower module case.

The lower module case and the upper module case are not limited to the above-described shape and may have a variety of structures for protecting the lithium-sulfur battery cell and the pressing structure from the outside. The detailed structure of other components of the module case, for example, the external terminal, may be included in those well known in the art.

In an embodiment of the present disclosure, the frame may connect the pressing structure to the battery module and may be a structure on which the pressing structure is mounted.

For example, the frame may have a shape of two or more bars or plates of a parallel structure.

The frame may be fastened to the inside of the battery module, for example, the opposite two inner sidewalls of the lower module case, or the bottom of the lower module case. The frame is used to mount the pressing structure on the battery module. The pressing structure may be connected to the frame. The pressing structure may be connected to the frame by a commonly used method.

For example, at least one of the plates included in the pressing structure may include a protruding portion extended outward from the side, and the protruding portion may be connected to the frame.

In an embodiment of the present disclosure, in the battery module, the frame may be connected to each of the opposite two inner sidewalls. In addition, the pressing structure may be mounted on the frame. One pressing structure may be mounted on the frame, but is not limited thereto, and a plurality of pressing structures may be mounted according to necessity.

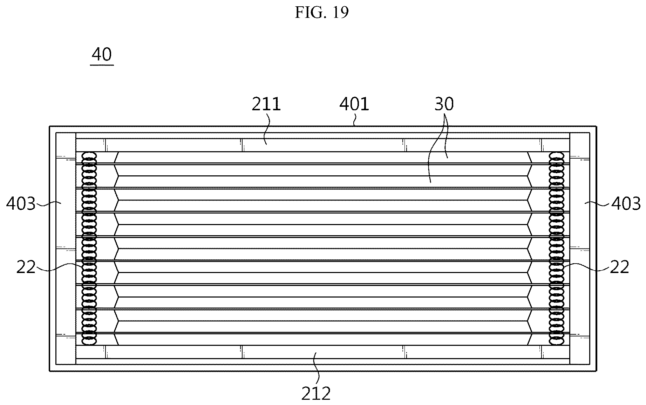

FIG. 19 is a cross-sectional view of the battery module 40 according to an embodiment of the present disclosure.

Referring to FIG. 19, the frame 403 may be mounted on each of the opposite two inner walls of the lower module case 401. In addition, the first plate 211 and the second plate 212 may be connected to the frames 403. The lithium-sulfur battery cell 30 may be mounted on the first plate 211 and/or the second plate 212.

In an embodiment of the present disclosure, the frame may include an actuator, and the actuator may be connected to the plate included in the pressing structure to move the plate. That is, the plate may be moved by the actuator to press the lithium-sulfur battery.

In this instance, the actuator may be connected to the outermost plate of the pressing structure.

For example, in the case of the pressing structure 20 shown in FIG. 5, both the first plate 211 and the second plate may be connected to the actuator.

Meanwhile, in the case of the pressing structure 20 shown in FIG. 7, the first plate 211 and the third plate 213 may be connected to the actuator, and the second plate 212 may not be connected to the actuator. The second plate 212 changes in location in response to the expansion and contraction of the lithium-sulfur battery (not shown) and the movement of the first plate and the third plate.

In the case of the pressing structure 20 shown in FIG. 11 and FIG. 14, the first plate 211 and the third plate 213 may be connected to the actuator, and the second plate 212 may not be connected to the actuator.

A third aspect of the present disclosure relates to a battery pack.

The battery pack according to an aspect of the present disclosure includes:
a battery pack case including a lower battery pack case and an upper battery pack case defining an internal space;
a cross beam to divide the internal space into a plurality of accommodation rooms; and
a battery module which is housed in the accommodation room,
wherein the battery module may be the battery module according to an aspect of the present disclosure.

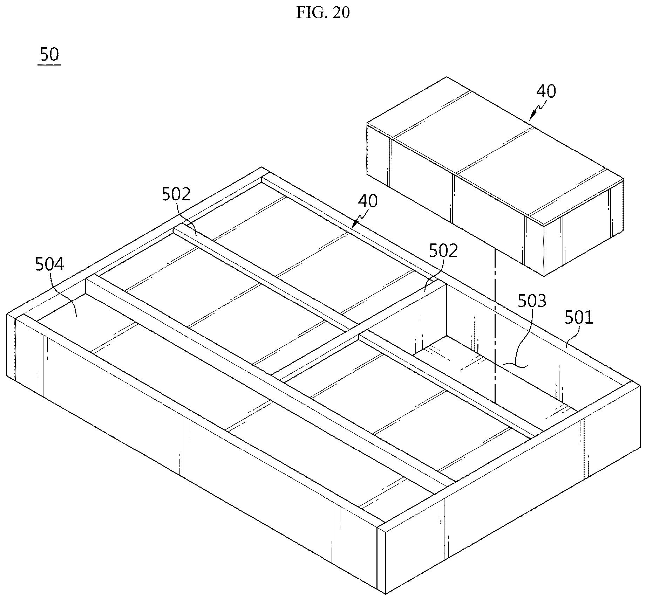

FIG. 20 is a perspective view of the battery pack 50 according to an embodiment of the present disclosure.

Referring to FIG. 20, the battery pack 50 may include the upper battery pack case (not shown), the lower battery pack case 501, the cross beam 502, the internal space and a battery control system 504.

The lower battery pack case 501 may include the internal space in which the battery module 40 is housed. The internal space may be divided into the plurality of accommodation rooms 503 by the cross beam 502. The lower battery pack case 501 may include bottom and sidewalls, and the bottom and the sidewalls may be substantially perpendicular to each other.

The accommodation room 503 may accommodate the battery module 40. When the battery module 40 is housed in the accommodation room 503, the bottom of the lower battery pack case 501 may support the battery module 40, and the sidewalls of the lower battery pack case 501 and/or the cross beam 502 may cover the battery module 40.

The battery control system 504 may include a Battery Management System (BMS) and a Battery Disconnect Unit (BDU). The BMS may be configured to control the charge and discharge, power and performance of the battery cells. The BDU may control the electrical connection of the battery cells to manage the power capacity and function of the battery pack. To this end, the BDU may include a power relay, a current sensor or a fuse.

When the battery pack 50 includes the plurality of battery modules 40, a bus bar electrically connecting the adjacent battery modules may be further included.

The battery pack 50 may include any other component commonly applied in the art, for example, a terminal connecting the battery modules 40 and other components although not expressly shown in the drawings.

The battery pack according to another aspect of the present disclosure may be a battery pack of a so-called cell-to-pack (CTP) structure, i.e., a structure in which the battery cells do not pass through the battery module and are directly connected to the battery pack structure.

That is, the battery pack according to an aspect of the present disclosure includes:
a battery pack case including a lower battery pack case and an upper battery pack case defining an internal space;
a cross beam to divide the internal space into a plurality of accommodation rooms;
a pressing structure which is housed in the accommodation room, and in which at least one lithium-sulfur battery cell is inserted; and
a frame to which the pressing structure is connected, wherein the pressing structure may be the pressing structure according to an aspect of the present disclosure.

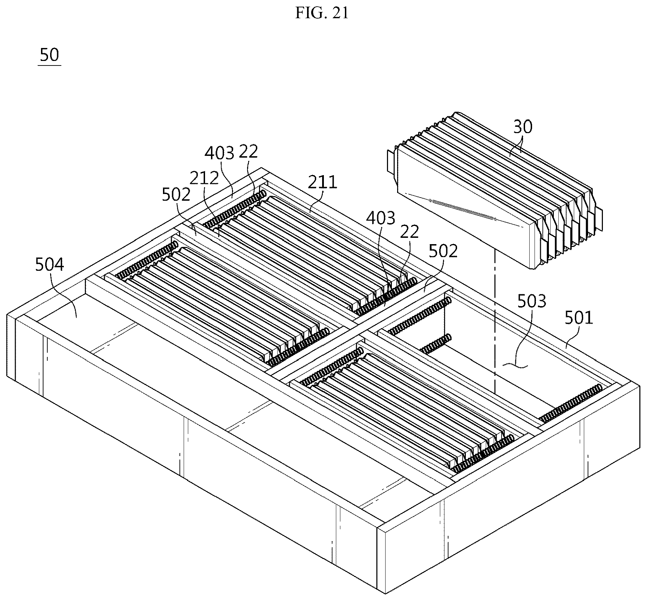

FIG. 21 is a perspective view of the battery pack 50 according to an embodiment of the present disclosure.

Referring to FIG. 21, the battery pack 50 may include the upper battery pack case (not shown), the lower battery pack case 501, the cross beam 502, the internal space and a battery control system 504.

The internal space may be divided into the plurality of accommodation rooms 503 by the cross beam 502. The battery pack 50 of the cell-to-pack structure may include the pressing structure housed in the accommodation room 503.

The accommodation room 503 may be formed by the bottom of the lower battery pack case 501 and the sidewalls of the lower battery pack case 501 and/or the cross beam 502 substantially perpendicular to the bottom of the lower battery pack case 501.

To connect the pressing structure, the frame 403 connecting the pressing structure may be mounted on the accommodation room 503. For example, the frame 403 may be mounted on the bottom of the lower battery pack case 501, or the frame 403 may be mounted on the sidewalls of the lower battery pack case 501 and/or the sides of the cross beam 502. FIG. 21 shows that the frame 403 is mounted on the inner sidewalls of the lower battery pack case 501, facing the opposite two sides of the cross beam 502.

The frame 403 and the pressing structure are the same as the foregoing description.

One or more battery cells 30 may be inserted into the pressing structure.

Each accommodation room 503 may accommodate a plurality of pressing structures, but in terms of energy density of the battery pack, it is preferable that each accommodation room 503 accommodates one pressing structure.

For the other components of the battery pack 50, the foregoing description may be applied, and the battery pack 50 may include any other component commonly applied in the art.

The battery pack 50 may include any other component commonly applied in the art, for example, a terminal connecting the battery modules 40 and other components although not expressly shown in the drawings.

In an embodiment of the present disclosure, the battery pack may be used in a wide range of device applications. Specifically, the battery pack may be applied to transportation devices such as electric bicycles, electric vehicles, hybrid electric vehicles, and Energy Storage Systems (ESS), but is not limited thereto and may be applied to a variety of devices using secondary batteries.

In an embodiment of the present disclosure, the lithium-sulfur battery inserted into the pressing structure for charge and discharge may include:
an electrode assembly including a positive electrode, a negative electrode and a separator interposed between the positive electrode and the negative electrode;
a battery case in which the electrode assembly is housed; and
an electrolyte which is injected into the battery case.

In an embodiment of the present disclosure, the positive electrode may include a positive electrode current collector and a positive electrode active material layer on one or two surfaces of the positive electrode current collector.

The positive electrode current collector is not limited to a particular type and may include anything that supports a positive electrode active material, and has high conductivity without causing any chemical change in the battery. For example, the positive electrode current collector may include copper, stainless steel, aluminum, nickel, titanium, palladium, sintered carbon, copper or stainless steel treated with carbon, nickel or silver on the surface, or aluminum-cadmium alloy.

The positive electrode current collector may have the microtextured surface to enhance the bond strength with the positive electrode active material, and may come in different forms, for example, film, sheet, foil, mesh, net, porous body, foam or non-woven.

The positive electrode active material layer includes the positive electrode active material and a binder polymer, and may optionally further include a conductive material and/or an additive.

The positive electrode active material may include sulfur (S). In this specification, a compound including sulfur is referred to as "sulfur-based compound". The sulfur-based compound may include, for example, any sulfur-containing compound produced through reduction reaction of inorganic sulfur (S₈) or oxidation reaction of lithium sulfide (Li₂S), and more specifically, inorganic sulfur (S₈), lithium sulfide (Li₂S), lithium polysulfide (Li₂Sx, an integer of 2 ≤ x ≤ 8), disulfide compounds, carbon-sulfur polymer ((C₂S_{y})ₙ, y = 2.5 to 50, n ≥ 2), lithium sulfide (Li₂S), or two or more of them.

Preferably, the positive electrode active material may include a sulfur-carbon composite. The sulfur-carbon composite may include a porous carbon material; and a sulfur-based compound loaded onto at least one of the inside of the pores of the porous carbon material and the outer surface of the porous carbon material.

In an embodiment of the present disclosure, the porous carbon material may be used to load the sulfur-based compound as the positive electrode active material, provide skeleton for holding the sulfur-based compound uniformly and stably and improve the conductivity of the positive electrode, and is not limited to a particular type and may include any porous carbon material.

The porous carbon material may be generally manufactured by carbonizing precursors of various carbon materials. The porous carbon material may include irregular pores therein, and have an average pore diameter ranging from 1 nm to 200 nm and a porosity ranging from 10 vol% to 90 vol% of the total volume of the porous carbon material. When the average pore diameter is below the aforementioned range, the pore size is only at the molecular level, making it impossible to incorporate sulfur, and on the contrary, when the average pore diameter is above the aforementioned range, it is not desirable for application to the electrode manufacturing process due to low mechanical strength of the porous carbon material.

The 'average pore diameter' may be measured by a known method for measuring the pore diameter of a porous material, and the measurement method is not limited to a particular one. For example, the pore diameter may be measured by scanning electron microscopy (SEM), field emission microscopy, laser diffraction or Brunauer-Emmett-Teller (BET) method. The measurement using the laser diffraction may use, for example, a commercially available laser diffraction particle size measurement device (for example, Microtrac MT 3000). In addition, the measurement by the BET method may use, for example, BEL Japan's BELSORP series analyzer, but is not limited thereto.

The 'porosity' refers to refers to the ratio of pore volume in a structure to its total volume and is indicated in %, and may be used interchangeably with void fraction, degree of porosity or the like. In the present disclosure, the measurement of the porosity is not limited to a particular method, and according to an embodiment of the present disclosure, for example, the porosity may be measured by the BET method using nitrogen gas, Hg porosimeter or ASTM D2873.

The porous carbon material may be spherical, rod-like, needle-like, platy, tubular or bulky in shape, and is not limited to a particular shape and may include any shape commonly used in the lithium-sulfur battery.

The porous carbon material may include any commonly used type of material having a porous structure or high specific surface area. For example, the porous carbon material may include at least one selected from the group consisting of graphite; graphene; carbon black such as Denka black, acetylene black, Ketjen black, channel black, furnace black, lamp black, and thermal black; carbon nanotubes (CNT) such as single-walled carbon nanotubes (SWCNT) or multi-walled carbon nanotubes (MWCNT); carbon fibers such as graphite nanofibers (GNF), carbon nanofibers (CNF), and activated carbon fibers (ACF); and graphite such as natural graphite, artificial graphite or expandable graphite and activated carbon, but is not limited thereto. Preferably, the porous carbon material may include carbon nanotubes.

A method for producing the sulfur-carbon composite is not limited to a particular one in the present disclosure, and may include any method commonly used in the art, for example, a method that simply mixes sulfur with the porous carbon material and performs thermal treatment to form a composite.

In addition to the above-described composition, the positive electrode active material may further include at least one selected from transition metal elements, Group IIIA elements, Group IVA elements, sulfur compounds of these elements, and alloys of these elements and sulfur.

The transition metal elements may include Sc, Ti, V, Cr, Mn, Fe, Co, Ni, Cu, Zn, Y, Zr, Nb, Mo, Tc, Ru, Rh, Pd, Os, Ir, Pt, Au or Hg. The Group ² elements may include Al, Ga, In or Ti. The Group ₃ elements may include Ge, Sn or Pb.

The sulfur-carbon composite may be included in an amount of 50 wt% or more based on the total weight of the positive electrode. Specifically, the sulfur-carbon composite may be included in an amount of 80 wt% or more, 90 wt% or more, or 95 wt% or more based on the total weight of the positive electrode active material layer. Specifically, the sulfur-carbon composite may be included in an amount of from 80 wt% to 100 wt%, more specifically from 85 wt% to 99 wt%, from 90 wt% to 99 wt%, from 95 wt% to 98 wt %, or from 95 wt% to 97 wt%, or 96 wt% based on the total weight of the positive electrode active material layer.

The binder polymer may hold the positive electrode active material onto the positive electrode current collector and bind the positive electrode active material to increase the bond strength, and may include any binder polymer well-known in the art.

For example, the binder polymer may include one selected from a fluororesin-based binder including polyvinylidene fluoride (PVdF), polyvinylidene fluoride-based polymer including at least one vinylidene fluoride as a repeating unit, polytetrafluoroethylene (PTFE) or a mixture thereof; a rubber-based binder including styrene butadiene rubber (SBR), acrylonitrile-butadiene rubber or styrene-isoprene rubber; an acrylic binder; a cellulose-based binder including carboxyl methyl cellulose (CMC), starch, hydroxy propyl cellulose or regenerated cellulose; a polyalcohol-based binder; a polyolefin-based binder including polyethylene or polypropylene; a polyimide-based binder; a polyester-based binder; and a silane-based binder; or a mixture or copolymer thereof.

The binder may be included in an amount of from 1 wt% to 10 wt% based on the total weight of the positive electrode active material layer. When the amount of the binder is below the aforementioned range, the positive electrode active material and the conductive material may be separated due to the poor physical properties of the positive electrode, and when the amount of the binder is above the aforementioned range, the battery capacity may decrease due to the smaller ratio of the positive electrode active material and the conductive material in the positive electrode, and accordingly, it is preferable to determine the optimal amount within the aforementioned range.

The conductive material is a material that electrically connects the electrolyte to the positive electrode active material and acts as a movement path of electrons from the current collector to the positive electrode active material, and may include, without limitation, any material having conductivity as the component of the electrode that is physically different from the carbon contained in the sulfur-carbon composite.

The conductive material may include, for example, carbon black such as Super-P, Denka black, acetylene black, Ketjen black, channel black, furnace black, lamp black, thermal black or carbon black; carbon derivatives such as carbon nanotubes or fullerene; conductive fibers such as carbon fibers or metal fibers; fluorocarbon; metal powder such as aluminum powder or nickel powder; or conductive polymer such as polyaniline, polythiophene, polyacetylene or polypyrrole, used singly or in combination.

The conductive material may be included in an amount of from 1 wt% to 10 wt% based on the total weight of the positive electrode active material. When the amount of the conductive material is below the aforementioned range, voltage and capacity may decrease due to slow electron transfer between the positive electrode active material and the current collector. On the contrary, when the amount of the conductive material is above the aforementioned range, the total energy (charge) of the battery may decrease due to the smaller ratio of the positive electrode active material, and accordingly it is preferable to determine the optimal amount within the aforementioned range.

In an embodiment of the present disclosure, the separator may separate or insulate the positive electrode from the negative electrode and allow for lithium ion transport between the positive electrode and the negative electrode. The separator be made of a porous nonconductive or insulating material, and is not limited to a particular type and may include any type of separator commonly used in the lithium secondary battery. The separator may include an independent member such as a film, or a coating layer formed on the positive electrode and/or the negative electrode.

Preferably, the separator may have low resistance to ion movement of the electrolyte and high electrolyte wettability.

In an embodiment of the present disclosure, the separator may include a porous substrate. The porous substrate may include any porous substrate commonly used in the secondary battery, and may include a porous polymer film used singly or in stack, for example, a nonwoven fabric made of high-melting-point glass fibers or polyethylene terephthalate fibers or a polyolefin-based porous film, but is not limited thereto.

The porous substrate is not limited to a particular material in the present disclosure, and may include any porous substrate commonly used in electrochemical devices. For example, the porous substrate may include at least one material selected from the group consisting of polyolefin such as polyethylene or polypropylene, polyester such as polyethyleneterephthalate or polybutyleneterephthalate, polyamide, polyacetal, polycarbonate, polyimide, polyetheretherketone, polyethersulfone, polyphenyleneoxide, polyphenylenesulfide, polyethylenenaphthalate, polytetrafluoroethylene, polyvinylidene fluoride, polyvinyl chloride, polyacrylonitrile, cellulose, nylon, poly(p-phenylene benzobisoxazole) and polyarylate.

The thickness of the porous substrate is not limited to a particular range, but may range from 1 *µ*m to 100 *µ*m, and preferably from 5 *µ*m to 50 *µ*m. The thickness range of the porous substrate is not limited to the aforementioned range, but when the thickness is much lower than the aforementioned lower limit, the mechanical properties may get worse, causing damage to the separator while the battery is in use.

The average pore diameter and porosity of the porous substrate are not limited to particular range, but may range from 0.001 *µ*m to 50 *µ*m and from 10 vol% to 95 vol%, respectively.

The separator may further include a porous coating layer on at least one surface of the porous substrate, the porous coating layer including inorganic particles and a binder.

The inorganic particles and the binder included in the porous coating layer may include those commonly used in the porous coating layer of the separator without particular limitation, and a method for manufacturing the same is also not limited to a particular one.

In an embodiment of the present disclosure, the negative electrode may include a current collector and a negative electrode active material layer on at least one surface of the current collector. Alternatively, the negative electrode may be a free-standing type free of a current collector, i.e., the negative electrode active material layer is not supported by the current collector and the negative electrode only has the negative electrode active material layer.

The current collector is not limited to a particular type and may include anything that supports the negative electrode active material and has high conductivity without causing any chemical change in the battery. For example, the current collector may include copper, stainless steel, aluminum, nickel, titanium, palladium, sintered carbon, copper or stainless steel treated with carbon, nickel or silver on the surface or aluminum-cadmium alloy. The current collector may have the microtextured surface to enhance the bond strength with the active material, and may come in different forms, for example, film, sheet, foil, mesh, net, porous body, foam or non-woven.

The negative electrode active material is characterized by including at least one of lithium metal or lithium alloy. The lithium alloy may include an alloy of lithium (Li) and metal selected from the group consisting of sodium (Na), potassium (K), rubidium (Rb), cesium (Cs), francium (Fr), beryllium (Be), magnesium (Mg), calcium (Ca), strontium (Sr), barium (Ba), radium (Ra), aluminum (Al) and tin (Sn).

In an embodiment of the present disclosure, the electrolyte solution includes the commonly used electrolyte components, for example, an organic solvent and an electrolyte salt. The electrolyte salt may include any salt having a structure of A⁺B⁻, where A⁺ includes an alkali metal cation such as Li⁺, Na⁺, K⁺ or a combination thereof, and B⁻ includes an anion such as PF₆⁻, BF₄⁻, Cl⁻, Br⁻, I⁻, ClO₄⁻, AsF₆⁻, CH₃CO₂⁻, CF₃SO₃⁻, N(CF₃SO₂)₂⁻, C(CF₂SO₂)₃⁻ or a combination thereof. In particular, a lithium salt is preferable. For example, LiClO₄, LiCF₃SO₃, LiPF₆, LiAsF₆, LiN(CF₃SO₂)₂ or a mixture thereof may be used.

The organic solvent used in the electrolyte solution may include any solvent commonly known in the art, for example, a cyclic carbonate-based solvent with or without a halogen substituent; a linear carbonate-based solvent; an ester-based solvent, a nitrile-based solvent, a phosphate-based solvent, or a mixture thereof. For example, the organic solvent may include propylene carbonate (PC), ethylene carbonate (EC), diethyl carbonate (DEC), dimethyl carbonate (DMC), dipropyl carbonate (DPC), dimethyl sulfoxide, acetonitrile, dimethoxyethane, diethoxyethane, tetrahydrofuran, N-methyl-2-pyrrolidone (NMP), ethyl methyl carbonate (EMC), gamma butyrolactone (GBL), fluoroethylene carbonate (FEC), methyl formate, ethyl formate, propyl formate, methyl acetate, ethyl acetate, propyl acetate, pentyl acetate, methyl propionate, ethyl propionate,, butyl propionate or a mixture thereof.

The electrolyte injection may be performed at a proper step of the battery manufacturing process according to the manufacturing process and required properties of the final product. That is, the electrolyte injection may be applied before battery assembly or at the final step of battery assembly.

In an embodiment of the present disclosure, the battery case may be cylindrical, prismatic, pouch-type or coin-type using a can. The lithium-sulfur battery according to an embodiment of the present disclosure may be a pouch-type secondary battery.

### Example 1

A second plate of 10 mm-thick aluminum was placed on the upper surface of a first plate of 10 mm-thick aluminum, and a third plate of 10 mm-thick aluminum was placed on the upper surface of the second plate.

The first plate and the second plate were connected with a silicone elastomer having density of 2.5 g/cm², and the second plate and the third plate were connected with a porous silicone elastomer having density of 0.75 g/cm² to manufacture a pressing structure.

### Comparative Example 1

A pressing structure was manufactured in the same way as Example 1, except that only the first plate and the second plate were used and the first plate and the second plate were not connected with an elastomer.

### Experimental Example 1: Cycle life test

### <Manufacture of lithium sulfur battery>

As a positive electrode active material, inorganic sulfur (S8) and carbon nanotubes (CNT) were mixed to prepare a sulfur-carbon composite (sulfur: SWCNT weight ratio 75:25), and 95 wt% of the prepared sulfur-carbon composite was mixed with 5 wt% of polyacrylate (PAA) as a binder polymer to prepare a positive electrode slurry composition. The positive electrode slurry composition was applied to an aluminum current collector and dried to manufacture a positive electrode. The loading of the manufactured positive electrode was 3.5 mAh/cm².

A 60 µm-thick lithium metal was prepared as a negative electrode.

An as-prepared electrode assembly was placed in a pouch-type case, and an electrolyte solution containing 1 M lithium bis(trifluoromethanesulfonyl)imide (LiTFSI) and 1 wt% lithium nitrate (LiNO₃) dissolved in a mixed solvent of 1,3-dioxolane (DOL) and dimethyl ether (DME ) at a 1:1 volume ratio was injected to manufacture a lithium-sulfur battery.

In the pressing structures of Example 1 and Comparative Example 1, the lithium-sulfur battery was inserted in between the first plate and the second plate.

Each lithium-sulfur battery was pressed at 1 MPa using each pressing structure, and charging and discharging was performed at 0.2C (charge) and 0.3C (discharge) in CC mode at 25°C. In this instance, the upper and lower limits of charge and discharge were 2.5 V and 1.8 V, respectively.

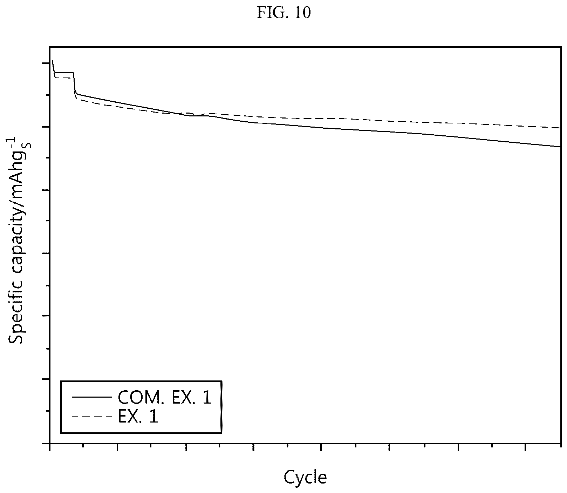

Additionally, FIG. 10 shows cycle life measurement results. Referring to FIG. 10, it was confirmed that Example 1 had less decline in discharge capacity over cycles than Comparative Example 1.

### Experimental Example 2: Test for structure maintenance when pressed

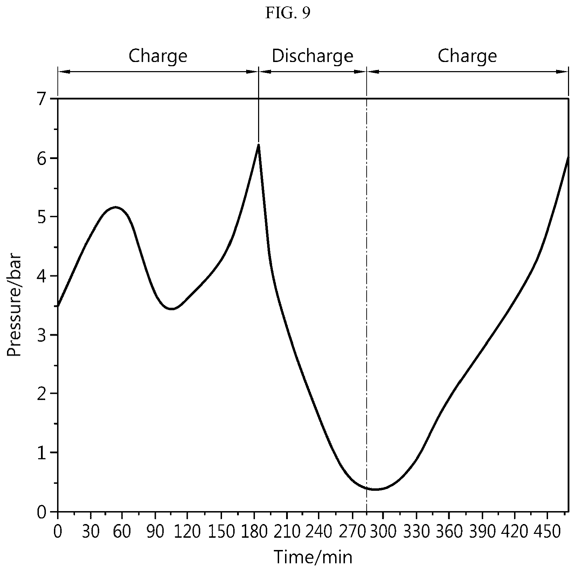

FIG. 9 shows the results of an experiment conducted to determine if the structure of the positive electrode is maintained when the pressing structure of Comparative Example 1 presses the lithium-sulfur battery manufactured in Experimental Example 1 after the lithium-sulfur battery is inserted into the pressing structure.

Referring to FIG. 9, the initial pressure of 3.5 bar was applied to the lithium-sulfur battery at SOC 0 at 25°C, charging was performed up to SOC 100 at 0.2C in a CC mode.

After the start of charging, as the negative electrode expanded, the pressure increased. Subsequently, after about 60 minutes from the start of charging, the rising pressure decreased. As lithium polysulfide was produced in the positive electrode, the structure of the positive electrode was weakened. Subsequently, in about 100 minutes, the pressure increased because of S₈ formation on the positive electrode during charging.

Subsequently, discharging was performed up to SOC 0 at 0.3C in a CC mode at 25°C. As lithium was released from the lithium negative electrode during the initial discharge, the volume decreased and the pressure dropped, and the pressure of 3.5 bar applied at the first time was not maintained and dropped below 0.5 bar. As the structure of the positive electrode was weakened, the initial thickness was not maintained, and the total thickness of the battery was reduced.

Although the present disclosure has been hereinabove described with regard to certain embodiments and drawings, the present disclosure is not limited thereto and it is obvious to those skilled in the art that a variety of modifications and changes may be made thereto within the technical aspect of the present disclosure and the scope of the appended claims and their equivalents.

## Claims

1. A pressing structure comprising:
a first plate on which at least one lithium-sulfur battery is mounted;
a second plate spaced a predetermined distance apart from an upper surface of the first plate; and
a first buffer member connecting the first plate to the second plate,
wherein the first buffer member changes in length in response to the distance between the first plate and the second plate.

2. The pressing structure according to claim 1, further comprising:
a third plate spaced a predetermined distance apart from an upper surface of the second plate; and
a second buffer member connecting the second plate to the third plate,
wherein the second buffer member changes in length in response to the distance between the second plate and the third plate.

3. The pressing structure according to claim 1, further comprising:
a first stopper located on the upper surface of the first plate and protruded toward a lower surface of the second plate,
wherein the first stopper stops the distance between the first plate and the second plate from decreasing below a predetermined distance.

4. The pressing structure according to claim 1, further comprising:
a first stopper located on a lower surface of the second plate and protruded toward the upper surface of the first plate,
wherein the first stopper stops the distance between the first plate and the second plate from decreasing below a predetermined distance.

5. The pressing structure according to claim 2, further comprising:
a second stopper located on the upper surface of the second plate and protruded toward a lower surface of the third plate,
wherein the second stopper stops the distance between the second plate and the third plate from decreasing below a predetermined distance.

6. The pressing structure according to claim 2, further comprising:
a second stopper located on a lower surface of the third plate and protruded toward the upper surface of the second plate,
wherein the second stopper stops the distance between the second plate and the third plate from decreasing below a predetermined distance.

7. The pressing structure according to claim 2,
wherein an elastic modulus of the first buffer member is greater than an elastic modulus of the second buffer member.

8. The pressing structure according to claim 2,
wherein each of the first buffer member and the second buffer member includes independently a spring or a rubber.

9. A battery module comprising:
a module case including a lower module case and an upper module case defining an internal space;
a pressing structure which is housed in the internal space and in which at least one lithium-sulfur battery cell is inserted; and
a frame to which the pressing structure is connected,
wherein the pressing structure is defined in claim 1.

10. The battery module according to claim 9,
wherein the frame has a shape of two or more bars or plates of a parallel structure.

11. The battery module according to claim 9,
wherein the frame includes an actuator,
wherein the actuator is connected to the first plate and the second plate,
wherein the first plate and the second plate are moved in a vertical direction by the actuator, and
wherein the pressing structure presses the lithium-sulfur battery by the movement of the first plate and the second plate.

12. A battery pack comprising:
a battery pack case including a lower battery pack case and an upper battery pack case defining an internal space;
a cross beam to divide the internal space into a plurality of accommodation rooms; and
a battery module which is housed in the accommodation room,
wherein the battery module is defined in claim 9.

13. A battery pack comprising:
a battery pack case including a lower battery pack case and an upper battery pack case defining an internal space;
a cross beam to divide the internal space into a plurality of accommodation rooms;
a pressing structure which is housed in the accommodation room, and in which at least one lithium-sulfur battery cell is inserted; and
a frame to which the pressing structure is connected,
wherein the pressing structure is defined in claim 1.

14. A device comprising the battery pack according to claim 12.

15. A device comprising the battery pack according to claim 13.
